# FASCICULE DE BREVET EUROPEEN

(11) **EP 1 195 049 B1**
(45) Date de publication et mention de la délivrance du brevet: **02.04.2003**
(21) Numéro de dépôt: 00946026.2
(22) Date de dépôt: 27.06.2000
(51) Int. Cl.: H04N 3/15

(54) **PROCEDE DE COMMANDE D'UN DISPOSITIF PHOTOSENSIBLE APTE A PRODUIRE DES IMAGES DE BONNE QUALITE**
STEUERUNGSVERFAHREN FÜR EINE LICHTEMPFINDLICHE VORRICHTUNG FÄHIG ZUR ERZEUGEUG VON BILDERN MIT GUTER QUALITÄT
METHOD FOR CONTROLLING A PHOTOSENSITIVE DEVICE FOR PRODUCING GOOD QUALITY IMAGES

(30) Priorité: 06.07.1999 FR 9908707
(43) Date de publication de la demande: 10.04.2002
(73) Titulaire: Trixell S.A.S., 38430 Moirans (FR)
(72) Inventeur: DUCOURANT, T., Thomson-CSF Prop. Intell. Dept., F-94117 Arcueil Cedex (FR); CHAUSSAT, C., Thomson-CSF Prop. Intell. Dept., F-94117 Arcueil Cedex (FR); NEYRET, R., Thomson-CSF Prop. Intell. Dept., F-94117 Arcueil Cedex (FR); BARNICHON, C., Thomson-CSF Prop. Intell. Dept., F-94117 Arcueil Cedex (FR); ATOYAN, C., Thomson-CSF Prop. Intell. Dept., F-94117 Arcueil Cedex (FR); APART, P., Thomson-CSF Prop. Intell. Dept., F-94117 Arcueil Cedex (FR)
(74) Mandataire: Guérin, Michel
(86) Numéro de dépôt international: FR0001795
(87) Numéro de publication internationale: WO01003419

(56) Documents cités:
- EP-A- 0 364 314
- FR-A- 2 760 585

## Description

La présente invention concerne un procédé de commande d'un dispositif photosensible formé d'au moins un point photosensible réalisé par des techniques de dépôt de matériaux semiconducteurs tels que le silicium amorphe. Elle a pour but de permettre des prises d'image à des instants aléatoires, les images produites par le dispositif photosensible possédant une qualité aussi bonne que possible notamment en termes de rémanence et de stabilité.

L'invention concerne plus particulièrement mais non exclusivement la commande de tels dispositifs utilisés à la détection d'images radiologiques.

Pour utiliser ces dispositifs photosensibles à la détection d'images radiologiques, on interpose entre le dispositif photosensible et le rayonnement X un scintillateur pour convertir le rayonnement X en rayonnement optique dans la bande de longueurs d'onde auxquels le point photosensible est sensible. Le matériau scintillateur est généralement de l'iodure de césium qui est connu pour sa faible rémanence intrinsèque.

Un point photosensible comprend généralement une photodiode associée à un élément de commutation à fonction d'interrupteur. La photodiode au moins est réalisée en matériau semiconducteur amorphe. Le point photosensible est monté entre un conducteur de ligne et un conducteur de colonne. Selon les besoins, le dispositif photosensible comporte alors une pluralité de points photosensibles agencés en matrice ou en barrette.

Le matériau semiconducteur amorphe produit de la rémanence. C'est lié à sa structure amorphe qui comporte un grand nombre de pièges, bien plus que dans les matériaux cristallins. Ces pièges sont des défauts de structure qui s'étendent sur toute la bande interdite. Ils retiennent des charges engendrées lors d'une prise d'image. Le matériau mémorise une image correspondant à une irradiation donnée et restitue des charges relatives à cette image au cours de la lecture de l'image suivante voire de plusieurs images suivantes. La qualité des images s'en ressent.

Un autre défaut affecte la qualité des images. Les composants semiconducteurs utilisés dans de tels dispositifs photosensibles ne sont pas tous identiques et le dispositif photosensible possède de manière inhérente des inhomogénéités qui se traduisent par des zones altérées et qui varient dans le temps.

Pour essayer d'obtenir une image utile de qualité optimale, on effectue une correction de l'image utile à partir d'une image dite d'offset connue sous la dénomination française d'image noire généralement prise et stockée en début d'un cycle de fonctionnement. Cette image d'offset est l'image obtenue alors que le dispositif photosensible est exposé à un signal d'intensité nulle et correspond à une sorte d'image de fond. L'image d'offset varie en fonction de l'état électrique des composants des points photosensibles et de la dispersion de leurs caractéristiques électriques.

L'image utile est celle lue alors que le dispositif photosensible a été exposé à un signal utile qui correspond à une exposition à un rayonnement X. Elle englobe l'image d'offset.

La correction consiste à effectuer une soustraction entre l'image utile et l'image d'offset. Cette correction n'est fiable que si l'image d'offset n'a pas varié entre le moment où elle a été prise et le moment où l'image utile est prise. Il faut que les points photosensibles soient dans le même état électrique juste avant la prise de l'image d'offset et avant celle de l'image utile. En l'absence de commande, les composants semiconducteurs sont à la recherche permanente d'un état d'équilibre qui peut être atteint en quelques heures car le temps mis pour remplir les pièges et celui mis pour les vider des charges stockées s'étalent sur des gammes de temps comprises entre quelques microsecondes et quelques minutes voire même quelques heures. Après ce laps de temps leur état peut encore varier en fonction de la température ou de variations infinitésimales d'irradiation résiduelle.

Puisque la prise de l'image d'offset se fait généralement en début de cycle de fonctionnement du dispositif photosensible et que la prise de l'image utile, déclenchée à la discrétion du radiologue, se fait de manière aléatoire lorsque le besoin s'en fait sentir, il n'y a aucune raison pour que les composants semiconducteurs soient tous dans le même état à ces deux instants qui sont séparés par un intervalle de temps variable.

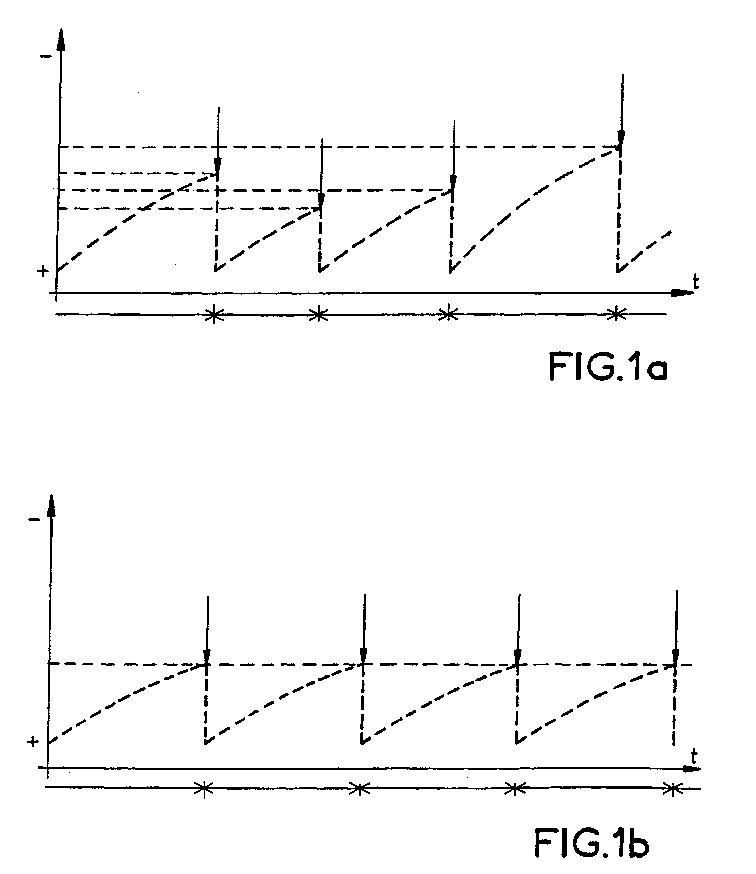

Les figures 1a, 1b symbolisent l'état de remplissage des pièges des composants d'un point photosensible d'un dispositif photosensible, auquel peut s'appliquer l'invention, au cours du temps. Les flèches représentent des cycles d'image. Par cycle d'image on entend la suite formée par une phase de prise d'image suivie d'une phase de lecture puis d'une phase d'effacement et de réinitialisation comme expliqué dans la demande de brevet FR-A-2 760 585. Durant la phase de prise d'image, les points photosensibles sont exposés à un signal à capter que ce signal soit un éclairement maximum ou l'obscurité, durant la phase de lecture une impulsion de lecture est appliquée aux conducteurs ligne adressés pour lire la quantité de charges accumulée lors de la prise d'image. Durant la phase d'effacement et de réinitialisation, les points photosensibles sont effacés, généralement optiquement et remis dans un état dans lequel ils sont réceptifs à une nouvelle prise d'image.

Entre deux cycles d'image successifs les points photosensibles sont laissés au repos mais leur état électrique évolue. On suppose que le premier cycle d'image représenté fournit l'image d'offset et les autres des images utiles à corriger avec l'image d'offset.

On voit bien que si les cycles d'image interviennent de manière aléatoire comme sur la figure 1a, les états électriques du point photosensible étant différents en début de cycle, les images utiles corrigées avec l'image d'offset ne peuvent être fiables.

En revanche, sur la figure 1b les cycles d'image interviennent de manière régulière, par exemple toutes les cinq secondes, et au début de chaque cycle l'état électrique du point photosensible est sensiblement le même.

L'image d'offset n'a pas fluctué et la correction d'une image utile prise pendant un cycle avec l'image d'offset prise pendant un autre cycle précédent est fiable. L'inconvénient majeur de ce mode de fonctionnement est qu'il apporte beaucoup de contraintes puisque les différents cycles doivent se succéder de manière périodique pour obtenir le résultat escompté.

Cette utilisation est très restrictive et n'est pas compatible ave les attentes des radiologues qui veulent pouvoir faire des demandes d'image selon leurs besoins. La présente invention propose d'éviter cet inconvénient majeur tout en garantissant une image de qualité optimum.

Selon l'invention, le procédé de commande d'un dispositif photosensible comprenant au moins un point photosensible avec une photodiode reliée à un élément de commutation consiste à soumettre le point photosensible à des cycles d'image successifs et entre un premier cycle d'image et un second cycle d'image à réaliser une phase de maintien se terminant au début du second cycle d'image. Durant cette phase de maintien dont la durée égale à plusieurs intervalles de temps égaux aussi courts que possible, le point photosensible est exposé à un flash optique en début de chaque intervalle de temps et entre les flashs optiques successifs la photodiode est polarisée en inverse, la zone de jonction entre la photodiode et l'élément de commutation ayant sensiblement un même potentiel à la fin de chaque intervalle de temps.

Un cycle d'image comporte une phase de prise d'image suivie d'une phase de lecture de la quantité de charges accumulées dans la zone de jonction lors de la phase de prise d'image, la phase de lecture étant suivie d'une phase d'effacement et de réinitialisation durant laquelle le point photosensible est exposé à un flux optique d'effacement mettant la photodiode en conduction dans le sens direct, et la photodiode étant polarisée en inverse en fin de phase d'effacement et de réinitialisation.

Pendant le fonctionnement de tels dispositifs, c'est un opérateur qui fait une demande d'image et un certain retard peut apparaître entre la demande et le début du cycle d'image correspondant, car on prévoit une synchronisation du début d'un cycle d'image avec la fin de l'intervalle de temps durant lequel intervient la demande de l'opérateur.

Pour s'affranchir d'éventuels problèmes de perturbations électriques, il est préférable que la fréquence des flashs optiques soit celle du secteur utilisé, par exemple 50 Hz ou 60 Hz.

En vue de simplifier les circuits de commande, il est préférable de laisser le point photosensible en état polarisé pendant toute la durée de la phase de maintien.

Dans le même but, il est préférable, pendant la phase d'effacement et de réinitialisation, d'appliquer au point photosensible une impulsion de polarisation débutant avant la fin de l'exposition au flux optique d'effacement et se prolongeant après.

Pendant la phase d'effacement et de réinitialisation, avant l'exposition du point photosensible au flux optique d'effacement, il est possible de l'exposer au moins une fois à un flux optique de pré-effacement provoquant la mise en conduction dans le sens direct de la photodiode de manière à améliorer l'effacement, lorsque des niveaux de rémanence très faibles sont requis.

L'exposition du point photosensible au flux optique de pré-effacement est suivi de la mise en polarisation inverse de la photodiode, cette mise en polarisation inverse de la photodiode intervenant avant l'exposition au flux optique d'effacement.

La phase de maintien débute le plus rapidement possible après la fin du premier cycle d'image de manière à conserver le point photosensible, en début de phase de maintien, sensiblement dans le même état qu'en fin du premier cycle d'image.

Pendant la phase de lecture, on applique au point photosensible une impulsion de lecture ayant le même signe que l'impulsion de polarisation et une amplitude supérieure ou égale.

La présente invention concerne aussi un dispositif photosensible mettant en oeuvre le procédé de commande. Il comporte au moins un point photosensible avec une photodiode reliée à un élément de commutation, des moyens pour exposer le point photosensible à une série de flashs optiques périodiques et des moyens pour mettre la photodiode en polarisation inverse

à l'issu d'un flash optique de manière à ce qu'elle soit dans un état réceptif dès le début du second cycle d'image.

D'autres caractéristiques et avantages de l'invention apparaîtront à la lecture de la description détaillée qui suit, faite à titre d'exemples non limitatifs en référence aux dessins annexés dans lesquels :
- les figures 1a, 1b, déjà décrites, représentent l'état des pièges des composants d'un point photosensible lors de son utilisation selon des procédés connus ;
- la figure 2 un dispositif photosensible auquel peut s'appliquer le procédé de l'invention ;
- les figures 3a à 3e des chronogrammes illustrant le fonctionnement du dispositif photosensible de la figure 2 sous la commande du procédé de l'invention ;
- les figures 4a à 4d des chronogrammes illustrant le fonctionnement du dispositif de la figure 2 sous la commande d'une variante du procédé de l'invention ;
- la figure 5 une variante d'un dispositif photosensible auquel peut s'appliquer le procédé de l'invention ;
- les figures 6a à 6d des chronogrammes illustrant le fonctionnement du dispositif photosensible de la figure 5 sous la commande du procédé de l'invention.

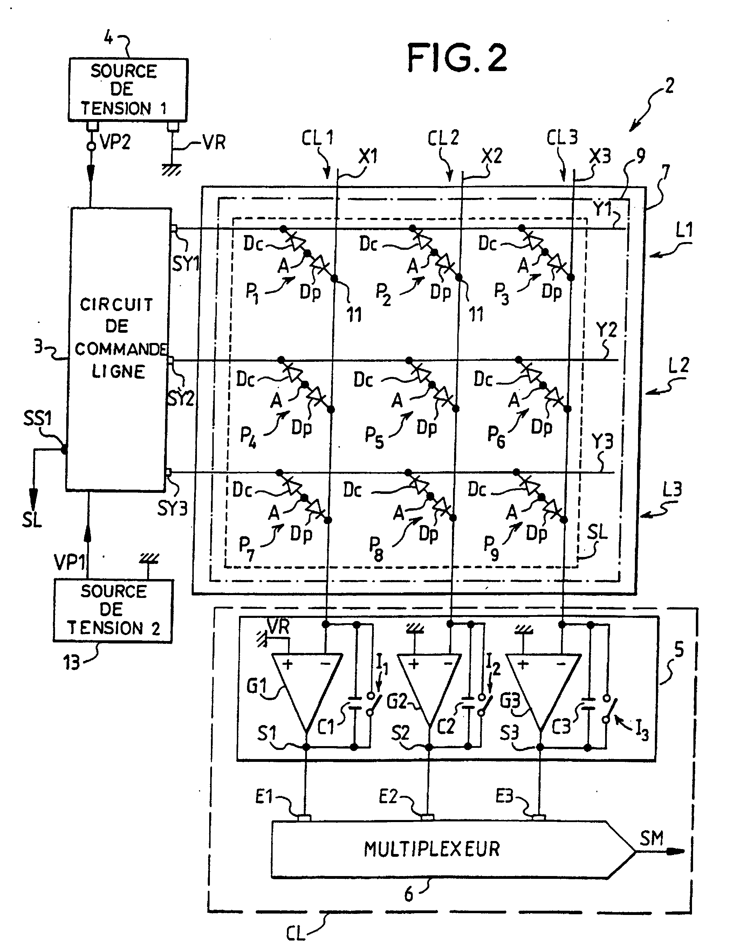

La figure 2 montre schématiquement un exemple d'un dispositif photosensible 2 auquel peut s'appliquer le procédé de l'invention. Il comporte des points photosensibles agencés en matrice et référencés P1 à P9. Chaque point photosensible est formé d'une photodiode Dp et d'une diode de commutation Dc montées en série suivant une configuration tête-bêche. La matrice comporte des conducteurs lignes Y1 à Y3 croisés avec des conducteurs colonnes X1 à X3, avec à chaque croisement, un point photosensible connecté entre un conducteur ligne et un conducteur colonne. Les points photosensibles P1 à P9 sont ainsi disposés suivant des lignes L1 à L3 et des colonnes CL1 à CL3.

Dans l'exemple de la figure 2, seulement 3 lignes et 3 colonnes sont représentées et elles définissent 9 points photosensibles, mais une telle matrice peut avoir une capacité beaucoup plus grande, pouvant aller jusqu'à plusieurs millions de points. Il est courant par exemple de réaliser de telles matrices ayant des points photosensibles disposés suivant 2000 lignes et 2000 colonnes (dans une surface de l'ordre de 40 cm x 40 cm) ou bien disposés suivant une unique ligne et plusieurs colonnes pour constituer une barrette de détection, ou encore disposés suivant une unique ligne et une unique colonne pour constituer un unique point photosensible.

Le dispositif photosensible comporte un circuit de commande ligne 3, dont des sorties SY1, SY2, SY3 sont reliées respectivement aux conducteurs lignes Y1, Y2, Y3. Le circuit de commande ligne 3 dispose de différents éléments (non représentés), tels que par exemple, circuit d'horloge, circuits de commutation, registre à décalage, qui lui permettent notamment de réaliser un adressage séquentiel des conducteurs lignes Y1 à Y3. Dans chaque point photosensible P1 à P9, les deux diodes Dp, Dc sont reliées entre elles soit par leur cathode, soit par leur anode comme dans l'exemple représenté. La cathode de la photodiode Dp est reliée à un conducteur colonne X1 à X3, et la cathode de la diode de commutation Dc est reliée à un conducteur ligne Y1 à Y3.

Les conducteurs colonne X1 à X3 sont reliés à un circuit de lecture CL, comprenant dans l'exemple un circuit intégrateur 5 et un circuit multiplexeur 6. Chaque conducteur colonne est relié à une entrée négative « - » d'un amplificateur G1 à G3 monté en intégrateur. Une capacité d'intégration C1 à C3 est montée entre l'entrée négative « - » et une sortie S1 à S3 de chaque amplificateur. La seconde entrée « + » de chaque amplificateur G1 à G3 est reliée à un potentiel qui dans l'exemple est le potentiel de référence VR, potentiel qui par suite est imposé à tous les conducteurs colonne X1 à X3. Chaque amplificateur comporte un élément interrupteur I1 à I3 dit de remise à zéro (constitué par exemple par un transistor du type MOS), monté en parallèle avec chaque capacité d'intégration C1 à C3.

Les sorties S1 à S3 des amplificateurs sont reliées aux entrées E1 à E3 du multiplexeur 6. Cette disposition classique permet de délivrer « en série » et ligne après ligne (L1 à L3), en sortie SM du multiplexeur 6, des signaux qui correspondent aux charges accumulées aux points « A » de tous les points photosensibles P1 à P9.

Il est à noter qu'il est connu aussi, pour remplir la fonction d'interrupteur qui dans l'exemple de la figure 2 est tenue par la diode de commutation Dc, d'utiliser un transistor; ce dernier présente par rapport à la diode une plus grande complexité de connexion, mais il offre des avantages dans la qualité de son état « passant », avantages qui seront évoqués dans la suite de la description.

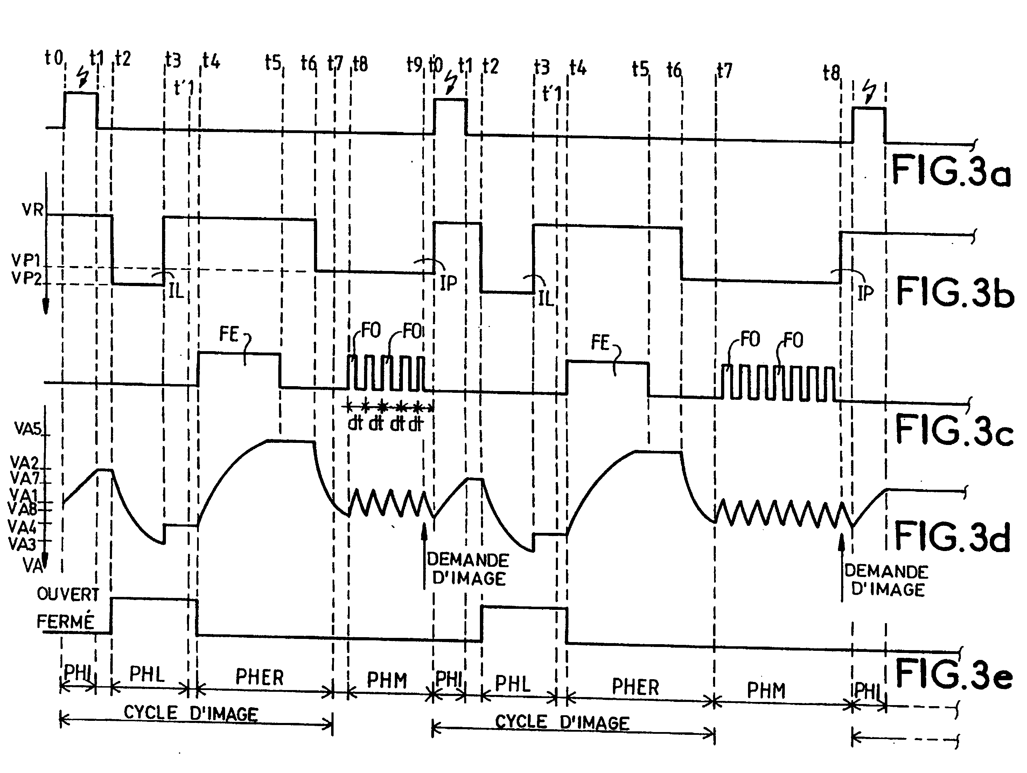

En prenant pour exemple le dispositif photosensible de la figure 2 dont chaque point photosensible comporte une diode de commutation Dc pour remplir la fonction d'interrupteur, on va maintenant décrire le déroulement du procédé de commande selon l'invention avec deux cycles d'image séparés par une phase de maintien. Les figures 3 sont des chronogrammes des différents évènements relatifs au procédé de commande selon l'invention. La figure 3a illustre les phases de prise d'image PHI, la figure 3b montre les signaux appliqués sur un conducteur ligne, Y1 par exemple, notamment en vue de la lecture, la figure 3c les signaux d'effacement d'un point photosensible P1 par exemple, la figure 3d les variations de la tension VA au point « A » qui est à la jonction entre la photodiode et l'élément de commutation du point P1 et la figure 3e permet de situer les instants pendant lesquels les interrupteurs de remise à zéro I1 à I3 passent de l'état fermé (0) à l'état ouvert (1) de manière à permettre l'intégration à l'état ouvert par les amplificateurs G1 à G3 des charges lues.

Dans l'exemple non limitatif décrit, on commence à l'instant t0 par le début d'un premier cycle d'image comportant tout d'abord une phase prise d'image PHI dans laquelle le point photosensible P1 va être exposé à un signal à capter, cette phase de prise d'image PHI est suivie d'une phase de lecture PHL. Les deux diodes Dp, Dc du point photosensible P1 considéré sont polarisées en inverse, et dans cet état elles constituent chacune une capacité. Il est à noter que généralement les deux diodes Dp, Dc sont conçues pour que la capacité présentée par la photodiode Dp soit la plus forte (de l'ordre par exemple de 50 fois). L'éclairement est compris entre un éclairement maximum et un éclairement nul au point que le point photosensible peut rester dans l'obscurité. C'est ce qui se passe notamment lors de la prise d'image d'offset.

L'éclairement crée une variation (ici une augmentation) de la tension VA au point A, cette variation est liée à la quantité de charges accumulée au point A sous l'effet de l'éclairement. La tension VA passe de VA1 à l'instant t0 à VA2 à l'instant t1 qui marque la fin de la phase de prise d'image PHI.

L'instant t2 marque le début de la phase de lecture PHL. Elle permet de lire la quantité de charge accumulée au point A lors de la phase de prise d'image PHI qui vient d'avoir lieu. La lecture des points photosensibles P1 à P9 s'effectue ligne par ligne, simultanément pour tous les points photosensibles P1 à P9 reliés à un même conducteur ligne Y1 à Y3. A cet effet, le circuit de commande ligne 3 applique à chaque conducteur ligne Y1 à Y3 adressé, une impulsion IL dite de lecture d'une amplitude donnée VP2; les conducteurs lignes qui ne sont pas adressés sont maintenus à un potentiel de référence VR ou potentiel de repos, qui est la masse par exemple, et qui peut être le même potentiel que celui qui est appliqué aux conducteurs colonne X1 à X3. Une source de tension 4, délivrant au circuit de commande ligne 3 la tension VP2 sert à définir l'amplitude des impulsions de lecture IL appliquées aux conducteurs lignes.

Entre l'instant t1 et l'instant t2, dans un but de simplification, nous avons négligé de représenter l'effet des courants d'obscurité qui font croître légèrement la tension VA. Le front de montée de l'impulsion de lecture IL qui a un signe négatif par rapport à une tension de référence VR et l'amplitude VP2 a pour action de mettre la diode de commutation Dc en conduction directe et cette dernière charge la capacité que constitue la photodiode Dp. La tension VA passe de la tension VA2 en décroissant de manière exponentielle à la tension VA3 à l'instant t3 où cesse l'impulsion IL de lecture et où la tension sur le conducteur ligne Y1 retourne à la valeur de référence VR.

La diode de commutation Dc est mise en polarisation inverse et constitue une capacité. A l'instant t3, la tension VA augmente de VA3 à VA4 par division capacitive.

Tous les conducteurs ligne Y1 à Y3 reçoivent l'un après l'autre une impulsion de lecture IL durant cette phase de lecture PHL qui cesse à l'instant t'1 mais le chronogramme de la figure 3b ne montre que l'impulsion de lecture appliquée au conducteur ligne Y1.

Ensuite, commence à l'instant t4 la phase d'effacement et de réinitialisation PHER qui vise à effacer les traces de la prise d'image précédente et à éviter toute corrélation entre la prise d'image précédente et une prise d'image future.

Cette phase comporte un effacement qui consiste à saturer les pièges existants dans le matériau semiconducteur des photodiodes Dp, suivi par une polarisation qui vise à mettre les points photosensibles P1 à P9 dans un état tel qu'ils soient réceptifs à une nouvelle prise d'image c'est-à-dire qu'ils puissent produire et accumuler des charges au cours de la nouvelle prise d'image.

L'effacement est provoqué par l'exposition des points photosensibles à un flux optique FE d'intensité et de durée suffisantes pour que les charges qu'il engendre au point « A » mettent la photodiode Dp en conduction dans le sens direct.

A partir de l'instant t4, la tension VA varie (en augmentant) jusqu'à atteindre une valeur VA5 avant la fin de l'application du flux d'effacement FE qui correspond à la tension de coude de la photodiode Dp. Cette dernière conduit dans son sens de conduction direct. La tension VA conserve la valeur VA5 jusqu'à l'instant t6 qui marque le début de l'application sur les conducteurs lignes d'une impulsion de polarisation IP ayant une amplitude VP1, négative par rapport à la tension de référence VR, c'est-à-dire ayant le même sens que l'impulsion de lecture IL. Une source de tension 13, délivrant au circuit de commande ligne 3 la tension VP1 sert à définir l'amplitude des impulsions de polarisation IP appliquées aux conducteurs lignes.

Cette impulsion de polarisation IP réinitialise les points photosensibles, c'est-à-dire replace les photodiodes Dp dans l'état de polarisation inverse de manière à ce qu'elles soient réceptives à une nouvelle prise d'image. Elles vont pouvoir de nouveau produire et accumuler des charges. A partir de l'instant t6 la tension VA décroît de manière à prendre la valeur VA1 égale à VP1 moins la tension de coude de la diode de commutation Dc à l'instant t7. Les points photosensibles P1 à P9 sont alors réinitialisés et ils ont totalement perdu la mémoire de l'image prise en début de cycle d'image à l'instant t0. La phase d'effacement et de réinitialisation PHER est terminée ainsi que le cycle d'image débuté à l'instant t0. Si un nouveau cycle d'image ne débute pas immédiatement après l'instant t7 et que le point photosensible P1 n'est plus sollicité, la tension VA va décroître jusqu'à ce que l'équilibre électrique soit atteint ce qui peut prendre plusieurs minutes voire quelques heures, la future prise d'image sera fonction de la durée entre l'instant t7 et l'instant t'0 marquant le début d'un second cycle d'image. Une phase de recherche d'équilibre électrique débute alors entre le courant inverse de la photodiode Dp, un courant de relaxation des pièges et le courant direct de la diode de commutation Dc. On se retrouve dans la même situation que celle décrite à la figure 1a si les cycles d'images ne sont pas réguliers.

Conformément à une caractéristique du procédé objet de l'invention, à partir d'un instant t8 qui suit l'instant t7 commence une phase de maintien PHM. Elle se termine à un instant t'0 qui marque le début d'un second cycle d'image. La durée de la phase de maintien est égale à un nombre entier d'intervalles de temps dt égaux, de durée aussi courte que possible, chaque intervalle de temps dt débute par une exposition des points photosensibles à un flash optique FO, pendant le reste de l'intervalle de temps dt les photodiodes sont en polarisation inverse. Autrement dit les points photosensibles sont exposés à une salve de flashs optiques FO périodiques de période dt aussi courte que possible.

Ainsi, pendant cette phase de maintien PHM, les points photosensibles sont maintenus dans un état électrique sensiblement constant.

L'exposition d'un point photosensible à un flash optique FO a pour effet de faire croître la tension VA jusqu'à une valeur VA7 et de faire remplir les pièges. Lorsqu'il cesse et que la photodiode est polarisée en inverse, les pièges se vident et la tension VA décroît jusqu'à une valeur VA8. On s'arrange pour que la tension VA conserve sensiblement la même valeur VA8 en fin de chaque intervalle de temps dt en ajustant la durée respective des flashs optiques FO et des intervalles de temps dt. Lorsqu'un nouveau flash optique est appliqué, la tension VA croit de nouveau jusqu'à VA7 et ainsi de suite. La tension VA va continuer à varier entre les deux bornes VA7, VA8 tant que se poursuit cette phase de maintien PHM. Dans l'exemple illustré aux figures 3, la polarisation en inverse des photodiodes Dp est obtenue par le maintien d'une impulsion de polarisation IP pendant toute la durée de la phase de maintien PHM. Plus précisément pour simplifier les commandes, il est préférable que l'impulsion de polarisation IP de la phase d'effacement et de réinitialisation PHER se poursuive pendant toute la phase de maintien car comme on l'expliquera ultérieurement, on cherche à ce que la phase de maintien PHM débute le plus rapidement possible après la fin de la phase d'effacement et de réinitialisation PHER.

La période dt des flashs optique est choisie aussi petite que possible, par exemple de l'ordre de 60 ms pour autoriser des demandes d'image les plus asynchrones possibles. En effet, lorsqu'un opérateur demande une image à un instant t9 par exemple, pendant un intervalle de temps dt de la phase de maintien PHM, le début du second cycle d'image est retardé jusqu'à l'instant t'0 qui correspond à la fin de l'intervalle de temps dt au cours duquel est intervenue la demande d'image. L'instant t'0 marque la fin des flashs optique et la fin de l'impulsion de polarisation IP. En d'autres termes, les cycles d'images sont synchronisés sur la fin d'un intervalle de temps dt.

Pour éviter des perturbations liées au champ électromagnétique ayant pour origine la fréquence du secteur, il est possible que les intervalles de temps dt soient rendus synchrones du secteur. Chaque intervalle de temps dt vaut alors par exemple 20 millisecondes si la fréquence du secteur est de 50Hz ou 16,66 millisecondes si elle vaut 60Hz comme aux Etats-Unis.

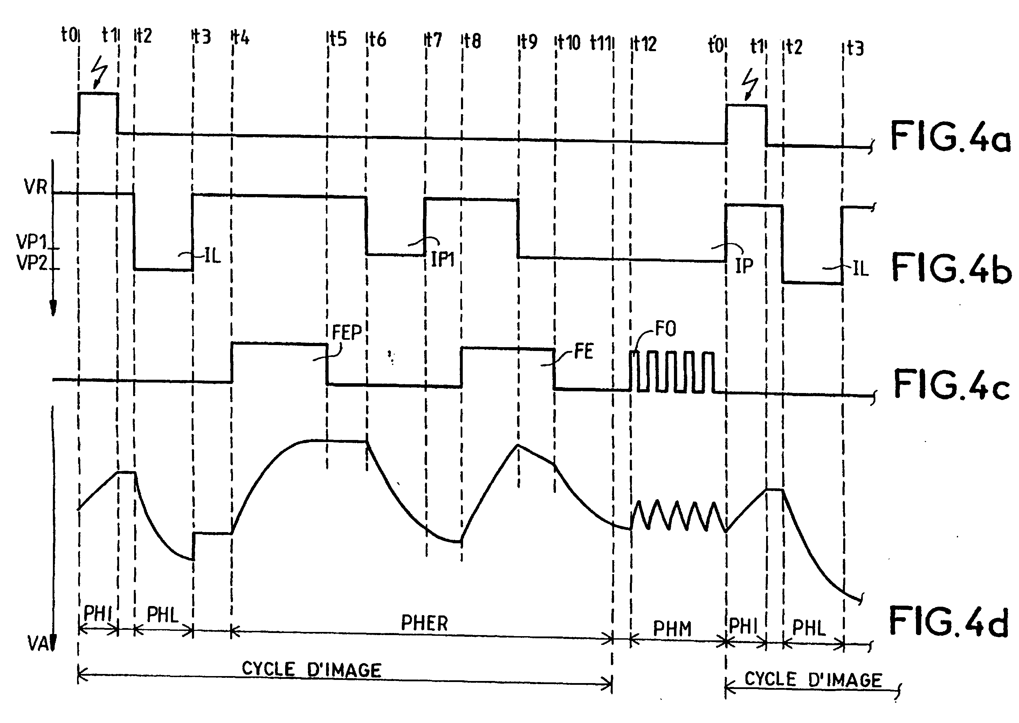

Pour améliorer encore l'efficacité de la phase d'effacement et de réinitialisation PHER par rapport à l'exemple décrit aux figures 3, si on ne tolère que des niveaux de rémanence très faibles, il est possible de prévoir avant l'exposition des points photosensibles au flux optique d'effacement FE, au moins une exposition à un flux optique de préeffacement FEP sans que les photodiodes ne soient contrôlées en polarisation. Les conducteurs lignes Y1 à Y3 sont au potentiel VR. Le flux optique de préeffacement a une intensité et une durée telles que la photodiode Dp passe en régime direct. A la fin du préeffacement FEP, on met en polarisation inverse les photodiodes en appliquant une impulsion de polarisation IP1 sur les conducteurs lignes Y1 à Y3, cette impulsion IP1 cessant avant l'exposition des points photosensibles à un nouvel éclairement c'est à dire soit un nouvel prééclairement FEP soit l'éclairement FE. Les chronogrammes des figures 4a à 4d montrent cette variante du procédé selon l'invention.

Les phases de prise d'image et de lecture se déroulent entre t0 ou t'0 et t3 et sont similaires à celles des figures 3 tandis que la phase d'effacement et de réinitialisation PHER a été allongée. La phase de maintien PHM est aussi similaire à ce qui a été décrit précédemment.

Dans l'exemple des figures 4, la phase d'effacement et de réinitialisation PHER débute à l'instant t4 avec au moins une exposition des points photosensibles à un flux optique de préeffacement FEP et ce jusqu'à l'instant t5. Les photodiodes Dp passent en conduction dans le sens direct et la tension VA croit jusqu'au moment où elle atteint la tension de coude des photodiodes Dp puis reste sensiblement constante jusqu'à l'instant t5 qui marque la fin de l'exposition au flux optique de préeffacement FEP. L'instant t6 marque le début de l'application d'une impulsion de polarisation IP1 d'amplitude VP1 qui vise à remettre les photodiodes Dp en état de polarisation inverse afin que les points photosensibles soient dans un état réceptif à une demande d'image ultérieure. La tension VA décroît pour tendre à l'instant t7, qui marque la fin de l'impulsion de polarisation IP1, vers la tension VP1 moins la tension de coude de la diode de commutation Dc. Après l'instant t7 l'effacement proprement dit peut commencer. Cet effacement débute à l'instant t8 par l'exposition à un flux optique FE d'effacement. Le déroulement du procédé correspond alors à ce qui a été décrit aux figures 3 à partir de l'instant t4 à l'exception du fait que l'impulsion de polarisation IP débute à l'instant t9 alors que le flux d'effacement FE n'a pas encore cessé. Entre l'instant t8 et l'instant t9 la tension VA croit jusqu'à ce que la photodiode Dp passe en conduction dans le sens direct. Entre l'instant t9 et l'instant t10 qui marque la fin de l'exposition au flux d'effacement FE, la tension VA commence à décroître avec une pente plus faible que si l'impulsion de polarisation IP s'appliquait seule. La pente s'accentue après l'instant t10 puisque le flux d'effacement FE a cessé.

La tension VA continue à décroître jusqu'à atteindre à l'instant t11 la tension VP1 moins la tension de coude de la diode de commutation Dc. A partir de cet instant t11, qui marque la fin de la phase d'effacement et de réinitialisation PHER, on procède le plus rapidement possible au début de phase de maintien PHM. Cette phase de maintien PHM débute à l'instant t12. Entre l'instant t11 et l'instant t12 l'état électrique des photodiodes varie et la tension VA continue de décroître. On s'arrange pour que l'intervalle de temps entre t11 et t12 soit au maximum de 500 millisecondes par exemple, pour que la tension VA conserve une valeur proche de celle atteinte en fin de phase d'effacement et de réinitialisation PHER. La valeur de 500 millisecondes n'est pas limitative. La phase de maintien est identique à ce qui a été décrit aux figures 3 entre les instants t8 et t'0.

Le flux optique ou les flux optiques de la phase d'effacement et de réinitialisation sont délivrés par une source SL qui est en elle-même classique. Elle peut être réalisée par exemple par une lumiplaque, un réseau de diodes luminescentes, un film photoluminescent.

Elle peut être disposée contre le substrat 7, à l'opposé des points photosensibles, s'il est transparent à la lumière. Il peut être en verre ou en quartz par exemple. Sur la figure 2, la source SL est schématisée par des pointillés, et en supposant que le substrat 7 soit dans le plan de la figure, elle serait située derrière. Elle pourrait bien sûr être située du côté des points photosensibles, dans la mesure où elle ne nuit pas à l'exposition des points lors d'une prise d'image.

La commande de la source SL peut être accomplie de manière classique à partir d'un signal délivré par une sortie SS1 du circuit de commande ligne 3.

La source permettant de fournir les flashs optiques FO peut être de même nature que celle SL qui délivre les flux optique d'effacement. La même source SL peut délivrer les flashs optiques et le flux d'effacement comme illustré sur la figure 2 mais ce n'est pas une obligation et des sources distinctes peuvent être prévues.

Les impulsions de polarisation IP ont une amplitude VP1 inférieure à celle VP2 des impulsions de lecture IL comme expliqué dans la demande de brevet français FR-A-2 760 585. Elles peuvent être appliquées à tous les conducteurs ligne Y1 à Y3 par le circuit de commande ligne 3, soit de manière simultanée, soit ligne après ligne.

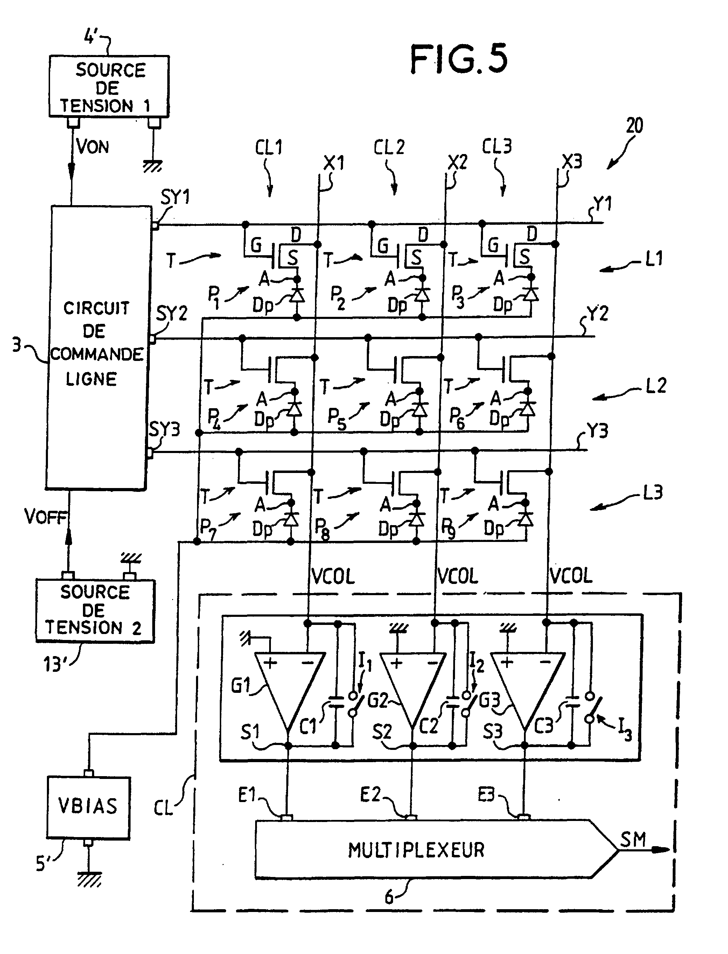

Au lieu que l'élément interrupteur Dc des points photosensibles P1 à P9 soit une diode de commutation comme l'illustre la figure 2, il est possible, comme l'illustre la figure 5, de la remplacer par un transistor T réalisé également par des techniques de dépôt de films en couches minces (TFT).

Dans le schéma de la figure 5, chaque transistor T est relié par sa source S à la cathode de la photodiode Dp, c'est-à-dire au point A, sa grille G est reliée au conducteur ligne Y1 à Y3 auquel appartient le point photosensible et son drain D est relié au conducteur colonne X1 à X3 auquel appartient le point photosensible. Les anodes de toutes les photodiodes Dp sont réunies et reliées à une alimentation spécifique 5' qui délivre une tension de polarisation VBIAS négative de l'ordre de -5 Volts à - 10 Volts et qui sert à constituer la polarisation en inverse des photodiodes Dp.

Le circuit de commande ligne 3 délivre par ses sorties SY1 à SY3 des signaux ou impulsions de tension qui en passant de VOFF à VON font passer simultanément tous les transistors T d'une même ligne respectivement de l'état bloqué à l'état passant. Le circuit de commande ligne 3 reçoit la tension VON d'une source de tension 4' et la tension VOFF d'une source de tension 13'. La tension VOFF est de l'ordre de -10 Volts tandis que la tension VON est de l'ordre de + 15 Volts.

La mise à l'état passant d'un transistor T provoque l'application de la tension VCOL, présente sur la colonne auquel est relié le drain D du transistor T, sur la cathode de la photodiode Dp auquel est relié le transistor. Cette tension VCOL est généralement de l'ordre de 0 Volt.

Le fonctionnement du point photosensible considéré est similaire à ce qui vient d'être décrit avec des diodes.

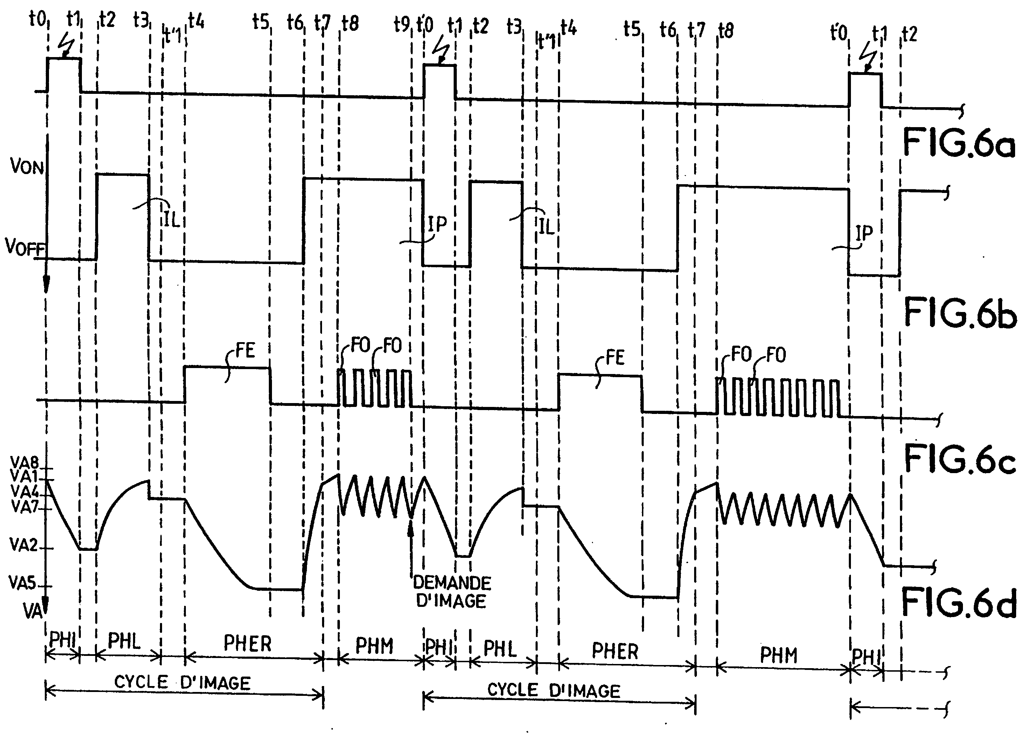

Toutefois, la tension VA à la jonction entre la photodiode Dp et le transistor T varie à l'inverse de celle d'un point photosensible avec deux diodes. Le chronogramme de la figure 6d est représenté comme reflété dans un miroir par rapport à celui de la figure 3d. En ce qui concerne les figures 6a et 6c, elles sont similaires à celles des figures 3a et 3c.

Quant à la figure 6b qui montre le signal appliqué au conducteur ligne du point photosensible considéré, seuls l'amplitude et le signe des impulsions appliquées varient par rapport à celles de la figure 3b. Lorsqu'il n'est pas adressé, le conducteur ligne considéré est maintenu au potentiel VOFF et lorsqu'il est adressé en lecture, il est porté par une impulsion de lecture IL à l'amplitude VON.

Une autre différence à souligner par rapport à l'exemple des figures 3 est que l'impulsion de polarisation IP a de préférence la même amplitude que l'impulsion de lecture IL, il n'est pas utile d'utiliser des charges d'entraînement comme l'expose la demande de brevet FR-A-2 760 585 parce que la qualité électrique d'un transistor à fonction d'interrupteur est meilleure que celle d'une diode.

Le procédé de l'invention est applicable à la commande de dispositifs photosensibles utilisés à la détection d'images radiologiques. Ces dispositifs comportent alors un scintillateur pour convertir un rayonnement incident, généralement un rayonnement X, en un rayonnement lumineux dans la bande de longueurs d'ondes auxquelles sont sensibles les photodiodes Dp. Sur le dispositif représenté à la figure 2, un scintillateur 9 est symbolisé par un carré en pointillés. Il peut être réalisé à partir d'iodure de césium qui est connu pour sa faible rémanence. Ce scintillateur 9 est déposé sur la matrice 2 de manière à être interposé entre cette dernière et le rayonnement X incident.

## Revendications

1. Procédé de commande d'un dispositif photosensible comprenant au moins un point photosensible (P1 à P9) avec une photodiode (Dp) reliée à un élément de commutation (Dc, T), consistant à soumettre le point photosensible à des cycles d'image successifs, **caractérisé en ce qu'**il consiste entre un premier cycle d'image et un second cycle d'image à réaliser une phase de maintien (PHM) se terminant au début du second cycle d'image, et **en ce que**, durant cette phase de maintien (PHM), dont la durée est égale à plusieurs intervalles de temps (dt) égaux aussi courts que possible, le point photosensible est exposé à un flash optique (FO) en début de chaque intervalle de temps et entre les flashs optiques successifs, la photodiode est polarisée en inverse, la zone de jonction entre la photodiode et l'élément de commutation ayant sensiblement un même potentiel (VA) à la fin de chaque intervalle de temps (dt).

2. Procédé de commande selon la revendication 1, **caractérisé en ce qu'**un cycle d'image comporte une phase de prise d'image (PHI) suivie d'une phase de lecture (PHL) de la quantité de charges accumulées dans la zone de jonction au cours de la phase de prise d'image, la phase de lecture étant suivie d'une phase d'effacement et de réinitialisation (PHER) durant laquelle le point photosensible est exposé à un flux optique (FE) d'effacement mettant la photodiode en conduction dans le sens direct, et la photodiode étant polarisée en inverse en fin de phase d'effacement et de réinitialisation.

3. Procédé de commande selon la revendication 2, dans lequel les cycles d'image sont demandés par un opérateur, **caractérisé en ce qu'**il synchronise le début d'un cycle d'image avec la fin de l'intervalle de temps durant lequel intervient la demande de l'opérateur.

4. Procédé de commande selon l'une des revendications 1 à 3, **caractérisé en ce que** la fréquence des flashs optiques est synchronisée sur celle du secteur.

5. Procédé de commande selon l'une des revendications 1 à 4, **caractérisé en ce qu'**il consiste à appliquer au point photosensible une impulsion de polarisation (IP) pendant toute la durée de la phase de maintien (PHM).

6. Procédé de commande selon l'une des revendications 2 à 5, lorsque les revendications 4 et 5 dépendent de l'une des revendications 2 et 3, **caractérisé en ce qu'**il consiste à, pendant la phase d'effacement et de réinitialisation (PHER), à appliquer au point photosensible une impulsion de polarisation (IP) débutant avant la fin de l'exposition au flux optique d'effacement (FE) et se prolongeant après.

7. Procédé de commande selon la revendication 6, **caractérisé en ce que** l'impulsion de polarisation (IP) de la phase d'effacement et de réinitialisation (PHER) se poursuit pendant la phase de maintien (PHM).

8. Procédé de commande selon l'une des revendications 2 à 7, lorsque les revendications 4 et 5 dépendent de l'une des revendications 2 et 3, **caractérisé en ce qu'**il consiste à, pendant la phase d'effacement et de réinitialisation (PHER), avant l'exposition du point photosensible au flux optique d'effacement, à exposer au moins une fois le point photosensible à un flux optique de pré-effacement (FEP) provoquant la mise en conduction dans le sens direct de la photodiode (Dp).

9. Procédé de commande selon la revendication 8, **caractérisé en ce que** l'exposition du point photosensible au flux optique de pré-effacement (FEP) est suivie de la mise en polarisation inverse de la photodiode, cette mise en polarisation inverse de la photodiode intervenant avant l'exposition au flux optique d'effacement (FE).

10. Procédé de commande selon la revendication 9, **caractérisé en ce qu'**il consiste à appliquer au point photosensible une impulsion de polarisation (IP1) débutant après la fin de l'exposition au flux optique de pré-effacement (FEP) et se terminant avant le début de l'exposition au flux optique d'effacement (FE).

11. Procédé de commande selon l'une des revendications 1 à 10, **caractérisé en ce qu'**il consiste à débuter la phase de maintien (PHM) le plus rapidement possible après la fin du premier cycle d'image.

12. Procédé de commande selon l'une des revendications 2 à 11, lorsque les revendications 4, 5 et 11 dépendent de l'une des revendications 2 et 3, **caractérisé en ce qu'**il consiste, pendant la phase de lecture (PHL), à appliquer au point photosensible une impulsion de lecture (IL) ayant le même signe que l'impulsion de polarisation (IP) et une amplitude supérieure ou égale.

13. Procédé de commande selon l'une des revendications 1 à 12, **caractérisé en ce que** l'élément de commutation est une diode (Dc).

14. Procédé de commande selon l'une des revendications 1 à 12, **caractérisé en ce que** l'élément de commutation est un transistor (T).

15. Procédé de commande selon l'une des revendications 1 à 14, le point photosensible étant réalisé sur une première face d'un substrat (7) transparent à la lumière, **caractérisé en ce qu'**il consiste à appliquer les flashs optiques au point photosensible à travers le substrat transparent.

16. Procédé de commande selon l'une des revendications 2 à 15, caractérisé en qu'il consiste à utiliser une même source (SL) pour délivrer les flashs optiques et le flux optique d'effacement.

17. Dispositif photosensible mettant en oeuvre le procédé de commande selon l'une quelconque des revendications 1 à 16, comportant au moins un point photosensible (P1 à P9) avec une photodiode (Dp) reliée à un élément de commutation (Dc), **caractérisé en ce qu'**il comporte des moyens (SL) pour exposer le point photosensible à une série de flashs optiques (FO) périodiques et des moyens (3, 13) pour mettre la photodiode en polarisation inverse à l'issu d'un flash optique de manière à ce qu'elle soit dans un état réceptif dès le début du second cycle d'image.

18. Dispositif selon la revendication 17, caractérisé en que les moyens pour mettre la photodiode en polarisation inverse permettent d'appliquer au point photosensible une impulsion de polarisation durant l'exposition à la série de flashs optiques.

19. Dispositif selon l'une des revendications 17 ou 18, **caractérisé en ce que** l'élément de commutation est une diode.

20. Dispositif selon l'une des revendications 17 ou 18, **caractérisé en ce que** l'élément de commutation est un transistor.

21. Dispositif selon l'une des revendications 17 à 20, **caractérisé en ce que** le point photosensible est réalisé sur une première face d'un substrat (7) transparent à la lumière et en **en ce qu'**il comporte une source (SL) pour délivrer les flashs optiques (FO), disposée sur la seconde face du substrat.

22. Dispositif photosensible selon l'une des revendications 17 à 21, **caractérisé en ce qu'**il comporte un scintillateur (9) convertissant un rayonnement X incident lors de la prise d'image en un rayonnement optique, la photodiode étant sensible au rayonnement optique.

## Patentansprüche

1. Steuerungsverfahren für eine lichtempfindliche Vorrichtung, die mindestens einen lichtempfindlichen Punkt (P1 bis P9) mit einer an ein Schaltelement (Dc, T) angeschlossenen Photodiode (Dp) enthält, wobei der lichtempfindliche Punkt aufeinanderfolgenden Bildzyklen unterworfen wird, **dadurch gekennzeichnet, daß** das Verfahren darin besteht, zwischen einem ersten und einem zweiten zu realisierenden Bildzyklus eine Wartungsphase (PHM) zu realisieren, die bei Beginn des zweiten Bildzyklus endet, und daß während dieser Wartungsphase (PHM), deren Dauer mehreren möglichst kurzen und gleich langen Zeitintervallen (dt) gleicht, der lichtempfindliche Punkt einem Lichtblitz FO zu Beginn jedes Zeitintervalls ausgesetzt ist und zwischen aufeinanderfolgenden Lichtblitzen die Photodiode in Sperrrichtung vorgespannt wird, wobei die Verbindungszone zwischen der Photodiode und dem Schaltelement im wesentlichen ein gleiches Potential am Ende jedes Zeitintervalls (dt) hat.

2. Steuerungsverfahren nach Anspruch 1, **dadurch gekennzeichnet, daß** ein Bildzyklus eine Bildaufnahmephase (PHI), danach eine Lesephase (PHL) zum Auslesen der in der Verbindungszone während der Bildaufnahmephase akkumulierten Ladungsmenge und danach eine Lösch- und Neuinitialisierungsphase (PHER) aufweist, während der der lichtempfindliche Punkt einem Löschlichtfluß (FE) ausgesetzt ist, welcher die Photodiode in Leitrichtung leitend macht, und daß die Photodiode am Ende der Lösch- und Neuinitialisierungsphase in Sperrrichtung vorgespannt wird.

3. Steuerungsverfahren nach Anspruch 2, bei dem die Bildzyklen von einer Bedienungsperson angefordert werden, **dadurch gekennzeichnet, daß** es den Beginn eines Bildzyklus mit dem Ende des Zeitintervalls synchronisiert, während dem die Bedienungsperson eine Bildaufnahme angefordert hat.

4. Steuerungsverfahren nach einem der Ansprüche 1 bis 3, **dadurch gekennzeichnet, daß** die Frequenz der Lichtblitze mit der Netzfrequenz synchronisiert ist.

5. Steuerungsverfahren nach einem der Ansprüche 1 bis 4, **dadurch gekennzeichnet, daß** es darin besteht, dem lichtempfindlichen Punkt einen Vorspannungsimpuls (IP) während der ganzen Dauer der Wartungsphase zuzuführen.

6. Steuerungsverfahren nach einem der Ansprüche 2 bis 5, sofern die Ansprüche 4 und 5 von einem der Ansprüche 2 und 3 abhängen, **dadurch gekennzeichnet, daß** es darin besteht, während der Lösch- und Neuinitialisierungsphase (PHER) an den lichtempfindlichen Punkt einen Vorspannungsimpuls (IP) anzulegen, der vor dem Ende der Bestrahlung mit dem Löschlichtfluß (FE) beginnt und über diesen hinaus andauert.

7. Steuerungsverfahren nach Anspruch 6, **dadurch gekennzeichnet, daß** der Vorspannungsimpuls (IP) der Löschund Neuinitialisierungsphase (PHER) während der Wartungsphase (PHM) weiter anliegt.

8. Steuerungsverfahren nach einem der Ansprüche 2 bis 7, sofern die Ansprüche 4 und 5 von einem der Ansprüche 2 und 3 abhängen, **dadurch gekennzeichnet, daß** es darin besteht, während der Lösch- und Neuinitialisierungsphase (PHER) vor der Bestrahlung des lichtempfindlichen Punkts mit dem Löschlichtfluß den lichtempfindlichen Punkt mindestens einmal einem Vor-Löschlichtimpuls (FEP) auszusetzen, der die Photodiode (Dp) in Leitrichtung leitend macht.

9. Steuerungsverfahren nach Anspruch 8, **dadurch gekennzeichnet, daß** nach der Bestrahlung des lichtempfindlichen Punkts mit dem Vor-Löschlichtimpuls (FEP) die Photodiode in Sperrrichtung vorgespannt wird, und zwar vor der Bestrahlung mit dem Löschlichtfluß (FE).

10. Steuerungsverfahren nach Anspruch 6, **dadurch gekennzeichnet, daß** es darin besteht, dem lichtempfindlichen Punkt einem Vorspannungsimpuls (IP1) zuzuführen, der nach dem Ende der Bestrahlung mit dem Vor-Löschlichtimpuls (FEP) beginnt und vor dem Beginn der Bestrahlung mit dem Löschlichtfluß (FE) endet.

11. Steuerungsverfahren nach einem der Ansprüche 1 bis 10, **dadurch gekennzeichnet, daß** es darin besteht, die Wartungsphase (PHM) möglichst schnell nach dem Ende des ersten Bildzyklus zu beginnen.

12. Steuerungsverfahren nach einem der Ansprüche 2 bis 11, sofern die Ansprüche 4, 5 und 11 von einem der Ansprüche 2 und 3 abhängen, **dadurch gekennzeichnet, daß** es darin besteht, während der Lesephase (PHL) an den lichtempfindlichen Punkt einen Leseimpuls (IL) anzulegen, der das gleiche Vorzeichen wie der Vorspannungsimpuls (IP) und eine größere oder gleich große Amplitude besitzt.

13. Steuerungsverfahren nach einem der Ansprüche 1 bis 12, **dadurch gekennzeichnet, daß** das Schaltelement eine Diode (Dc) ist.

14. Steuerungsverfahren nach einem der Ansprüche 1 bis 12, **dadurch gekennzeichnet, daß** das Schaltelement ein Transistor (T) ist.

15. Steuerungsverfahren nach einem der Ansprüche 1 bis 14, in dem der lichtempfindliche Punkt auf einer ersten Seite eines für Licht transparenten Substrats (7) realisiert ist, **dadurch gekennzeichnet, daß** die Lichtblitze auf den lichtempfindlichen Punkt durch das transparente Substrat hindurch einwirken.

16. Steuerungsverfahren nach einem der Ansprüche 2 bis 15, **dadurch gekennzeichnet, daß** es darin besteht, eine gemeinsame Quelle (SL) zur Lieferung der Lichtblitze und des Löschlichtflusses zu verwenden.

17. Lichtempfindliche Vorrichtung zur Durchführung des Steuerungsverfahrens nach einem beliebigen der Ansprüche 1 bis 16, die mindestens einen lichtempfindlichen Punkt (P1 bis P9) mit einer an ein Schaltelement (Dc) angeschlossenen Photodiode (Dp) aufweist, **dadurch gekennzeichnet, daß** es Mittel (SL), um den lichtempfindlichen Punkt einer Serie von periodischen Lichtblitzen (FO) auszusetzen, sowie Mittel (3, 13) enthält, um die Photodiode nach einem Lichtblitz in Sperrrichtung vorzuspannen, sodaß die Photodiode bei Beginn des zweiten Bildzyklus empfangsbereit ist.

18. Vorrichtung nach Anspruch 17, **dadurch gekennzeichnet, daß** die Mittel, um die Photodiode in Sperrrichtung vorzuspannen, dem lichtempfindlichen Punkt einen Vorspannungsimpuls während der Bestrahlung durch die Serie von Lichtblitzen zuführen können.

19. Vorrichtung nach einem der Ansprüche 17 und 18, **dadurch gekennzeichnet, daß** das Schaltelement eine Diode ist.

20. Vorrichtung nach einem der Ansprüche 17 und 18, **dadurch gekennzeichnet, daß** das Schaltelement ein Transistor ist.

21. Vorrichtung nach einem der Ansprüche 17 bis 20, **dadurch gekennzeichnet, daß** der lichtempfindliche Punkt auf einer ersten Seite eines lichtdurchlässigen Substrats (7) realisiert ist und daß eine Quelle (SL) zur Lieferung der Lichtblitze (FO) auf der zweiten Seite des Substrats vorgesehen ist.

22. Lichtempfindliche Vorrichtung nach einem der Ansprüche 17 bis 21, **dadurch gekennzeichnet, daß** sie einen Scintillator (9) enthält, der eine einfallende Röntgenstrahlung bei der Bildaufnahme in eine Lichtstrahlung umwandelt, für die die Photodiode empfindlich ist.

## Claims

1. Process for controlling a photosensitive device comprising at least one photosensitive point (P1 to P9) with a photodiode (Dp) connected to a switching element (Dc, T), consisting in submitting the photosensitive point to successive imaging cycles, **characterized in that** it consists, between a first imaging cycle and a second imaging cycle, in producing a holding phase (PHM) terminating at the start of the second imaging cycle, and **in that**, during this holding phase (PHM), whose duration is equal to several equal time intervals (dt) which are as short as possible, the photosensitive point is exposed to an optical flash (FO) at the start of each time interval and between the successive optical flashes, the photodiode is reverse biased, the junction region between the photodiode and the switching element having substantially the same potential (VA) at the end of each time interval (dt).

2. Control process according to Claim 1, **characterized in that** an imaging cycle comprises an imaging phase (PHI) followed by a phase (PHL) of reading the amount of charge accumulated in the junction region during the imaging phase, the read phase being followed by an erasure and reinitialization phase (PHER), during which the photosensitive point is exposed to an optical erasure flux (FE) causing the photodiode to conduct in the forward direction, and the photodiode to be reverse biased at the end of the erasure and reinitialization phase.

3. Control process according to Claim 2, in which the imaging cycles are requested by an operator, **characterized in that** it synchronizes the start of an imaging cycle with the end of the time interval during which the operator's request occurs.

4. Control process according to one of Claims 1 to 3, **characterized in that** the frequency of the optical flashes is synchronized with that of the mains.

5. Control process according to one of Claims 1 to 4, **characterized in that** it consists in applying a biasing pulse (IP) to the photosensitive point for the entire duration of the holding phase (PHM).

6. Control process according to one of Claims 2 to 5, when Claims 4 and 5 depend on one of Claims 2 and 3, **characterized in that** it consists, during the erasure and reinitialization phase (PHER), in applying to the photosensitive point a biasing pulse (IP) starting before the end of the exposure to the optical erasure flux (FE) and continuing thereafter.

7. Control process according to Claim 6, **characterized in that** the biasing pulse (IP) of the erasure and reinitialization phase (PHER) is continued during the holding phase (PHM).

8. Control process according to one of Claims 2 to 7, when Claims 4 and 5 depend on one of Claims 2 and 3, **characterized in that** it consists, during the erasure and reinitialization phase (PHER), before the exposure of the photosensitive point to the optical erasure flux, in exposing the photosensitive point at least once to an optical pre-erasure flux (FEP) causing the photodiode (Dp) to conduct in the forward direction.

9. Control process according to Claim 8, **characterized in that** the exposure of the photosensitive point to the optical pre-erasure flux (FEP) is followed by the reverse biasing of the photodiode, this reverse biasing of the photodiode occurring before exposure to the optical erasure flux (FE).

10. Control process according to Claim 9, **characterized in that** it consists in applying to the photosensitive point a biasing pulse (IP1) starting after the end of the exposure to the optical pre-erasure flux (FEP) and terminating before the start of the exposure to the optical erasure flux (FE).

11. Control process according to one of Claims 1 to 10, **characterized in that** it consists in starting the holding phase (PHM) as quickly as possible after the end of the first imaging cycle.

12. Control process according to one of Claims 2 to 11, when Claims 4, 5 and 11 depend on one of Claims 2 and 3, **characterized in that** it consists, during the read phase (PHL), in applying to the photosensitive point a read pulse (IL) having the same sign as and an amplitude greater than or equal to the biasing pulse (IP).

13. Control process according to one of Claims 1 to 12, **characterized in that** the switching element is a diode (Dc).

14. Control process according to one of Claims 1 to 12, **characterized in that** the switching element is a transistor (T).

15. Control process according to one of Claims 1 to 14, the photosensitive point being produced on a first face of a substrate (7) transparent to light, **characterized in that** it consists in applying the optical flashes to the photosensitive point through the transparent substrate.

16. Control process according to one of Claims 2 to 15, **characterized in that** it consists in using the same source (SL) in order to deliver the optical flashes and the optical erasure flux.

17. Photosensitive device implementing the control process according to any one of Claims 1 to 16, comprising at least one photosensitive point (P1 to P9) with a photodiode (Dp) connected to a switching element (Dc), **characterized in that** it comprises means (SL) for exposing the photosensitive point to a series of periodic optical flashes (FO) and means (3, 13) to reverse bias the photodiode at the end of an optical flash so that it is in a receptive state from the start of the second imaging cycle.

18. Device according to Claim 17, **characterized in that** the means to reverse bias the photodiode make it possible to apply to the photosensitive point a biasing pulse during the exposure to the series of optical flashes.

19. Device according to either of Claims 17 and 18, **characterized in that** the switching element is a diode.

20. Device according to either of Claims 17 and 18, **characterized in that** the switching element is a transistor.

21. Device according to one of Claims 17 to 20, **characterized in that** the photosensitive point is produced on a first face of a substrate (7) transparent to light and **in that** it comprises a source (SL) for delivering the optical flashes (FO), placed on the second face of the substrate.

22. Photosensitive device according to one of Claims 17 to 21, **characterized in that** it comprises a scintillator (9) converting X-ray radiation incident on taking the image into optical radiation, the photodiode being sensitive to the optical radiation.
